# FASCICULE DE BREVET EUROPEEN

(11) **EP 3 853 882 B1**
(45) Date de publication et mention de la délivrance du brevet: **26.10.2022**
(21) Numéro de dépôt: 19769164.5
(22) Date de dépôt: 17.09.2019
(51) Int. Cl.: H01L 21/265, H01L 21/02, H01L 29/20, H01L 31/18, H01L 33/00, H01L 33/12, H01L 27/15, H01L 33/02

(54) **PROCÉDÉ DE FABRICATION D'UN DISPOSITIF ÉLECTRONIQUE**
VERFAHREN ZUR HERSTELLUNG EINER ELEKTRONISCHEN VORRICHTUNG
METHOD FOR MANUFACTURING AN ELECTRONIC DEVICE

(30) Priorité: 18.09.2018 FR 1858391
(43) Date de publication de la demande: 28.07.2021
(73) Titulaire: Commissariat à l'Energie Atomique et aux Energies Alternatives, 75015 Paris (FR)
(72) Inventeur: BONO, Hubert, 38054 GRENOBLE CEDEX 9 (FR)
(74) Mandataire: Cabinet Beaumont
(86) Numéro de dépôt international: PCT/EP2019/074840
(87) Numéro de publication internationale: WO 2020/058256

(56) Documents cités:
- EP-A1- 1 014 430
- EP-A2- 0 871 208
- JP-A- 2009 239 315
- US-A- 4 494 997
- US-A- 4 509 990

## Description

La présente demande de brevet revendique la priorité de la demande de brevet français FR18/58391.

### Domaine technique

La présente description concerne de façon générale les dispositifs électroluminescents à base de matériaux semiconducteurs et leurs procédés de fabrication. Elle vise plus particulièrement un procédé de fabrication d'un dispositif électroluminescent à base de nitrure d'indium-gallium (InGaN) ou de nitrure d'aluminium-gallium (AlGaN).

### Technique antérieure

Un dispositif électroluminescent comprend classiquement une ou plusieurs cellules électroluminescentes adaptées à convertir un signal électrique en un rayonnement lumineux. Chaque cellule électroluminescente peut comprendre un empilement d'une première couche semiconductrice d'un premier type de conductivité connectée électriquement à une électrode d'anode ou de cathode de la cellule, d'une couche active, et d'une deuxième couche semiconductrice dopée du second type de conductivité connectée électriquement à une électrode de cathode ou d'anode de la cellule. En fonctionnement, un courant électrique est appliqué entre les première et deuxième couches semiconductrices de la cellule. Sous l'effet de ce courant, la couche active émet un rayonnement lumineux dans une gamme de longueurs d'ondes qui dépend essentiellement de sa composition.

On a notamment proposé des cellules électroluminescentes dans lesquelles la couche active comprend une ou plusieurs couches d'InGaN, ou une ou plusieurs couches d'AlGaN. Dans de telles cellules, la longueur d'onde d'émission dépend notamment de la concentration d'indium dans les couches d'InGaN de la couche active, ou de la concentration d'aluminium dans les couches d'AlGaN de la couche active. Plus particulièrement, dans les cellules électroluminescentes à base d'InGaN, la longueur d'onde d'émission se décale du bleu vers le rouge lorsque la concentration d'indium dans les couches d'InGaN de la couche active augmente. De façon similaire, dans les cellules électroluminescentes à base d'AlGaN, la longueur d'onde d'émission se décale du bleu vers l'ultraviolet lorsque la concentration d'aluminium dans les couches d'AlGaN de la couche active augmente.

Une difficulté qui se pose est que, dans les procédés connus de fabrication de cellules électroluminescentes à base d'InGaN ou d'AlGaN, l'augmentation de la concentration d'indium dans les couches d'InGaN de la couche active ou de la concentration d'aluminium dans les couches d'AlGaN de la couche active entraîne une dégradation de la qualité cristalline de la couche active, ce qui conduit à dégrader les performances des cellules. Cette limitation résulte notamment des désaccords de paramètres de maille entre les couches d'InGaN ou d'AlGaN de la couche active et une couche de base sous-jacente, généralement en nitrure de gallium (GaN), désaccords d'autant plus importants que la concentration d'indium dans les couches d'InGaN de la couche active ou d'aluminium dans les couches d'AlGaN de la couche active est élevée.

Ainsi, s'il est théoriquement possible, dans des cellules électroluminescentes à base d'InGaN, de couvrir la totalité du spectre visible en adaptant la concentration d'indium dans les couches d'InGaN de la couche active, il est en pratique difficile voire impossible de fabriquer des dispositifs performants présentant une concentration d'indium élevée dans les couches d'InGaN de la couche active. Il en résulte qu'une partie du spectre théoriquement disponible reste en pratique inaccessible. De façon similaire, s'il est théoriquement possible, dans les cellules électroluminescentes à base d'AlGaN, de couvrir un spectre étendu allant du bleu à l'ultraviolet en adaptant la concentration d'aluminium dans les couches d'AlGaN de la couche active, il est en pratique difficile voire impossible de réaliser des dispositifs présentant une concentration d'aluminium élevée dans les couches d'AlGaN de la couche active ou dans les couches d'injection de porteurs de charge entourant la couche active, de sorte qu'une partie du spectre théoriquement disponible reste en pratique inaccessible.

Le document EP 0 871 208 A2 divulgue un procédé basé sur l'implantation d'azote (N) dans une couche en nitrure de gallium (GaN) afin, après amorphisation puis recristallisation de ladite couche implantée, d'y obtenir du GaN comportant moins de dislocations.

### Résumé de l'invention

La présente invention prévoit un procédé de fabrication d'un dispositif électronique selon la revendication 1 en annexe, comportant les étapes successives suivantes :
a) réaliser une implantation ionique d'indium ou d'aluminium dans une partie supérieure d'une première couche monocristalline de nitrure de gallium, de façon à rendre amorphe la partie supérieure de la première couche et à préserver la structure cristalline d'une partie inférieure de la première couche ; et
b) réaliser un recuit de recristallisation en phase solide de la partie supérieure de la première couche, conduisant à transformer la partie supérieure de la première couche en une couche cristalline de nitrure d'indium-gallium ou de nitrure d'aluminium-gallium.

Les revendications dépendantes en annexe prévoient divers autres modes, plus spécifiques, de réalisation de la présente invention.

Selon un mode de réalisation, le procédé comprend en outre, après l'étape b), une étape c) de dépôt, par épitaxie en phase vapeur, sur la face supérieure de la première couche, d'une structure électroluminescente comprenant :
- une couche semiconductrice dopée d'un premier type de conductivité revêtant la face supérieure de la première couche ;
- une couche active revêtant la face supérieure de la couche semiconductrice dopée du premier type de conductivité ; et
- une couche semiconductrice dopée du second type de conductivité revêtant la face supérieure de la couche active.

Selon un mode de réalisation, lors des étapes a) et b), une couche de protection recouvre la face supérieure de la première couche.

Selon un mode de réalisation, lors de l'étape a), les conditions d'implantation sont choisies de façon que la partie inférieure de la première couche présente une épaisseur inférieure au cinquième de l'épaisseur de la première couche.

Selon un mode de réalisation, lors de l'étape a), une implantation complémentaire d'azote est réalisée pour compenser l'apport d'indium ou d'aluminium dans la partie supérieure de la première couche.

Selon un mode de réalisation, les énergies d'implantation sont choisies de façon que les profils de concentration d'indium et d'azote ou d'aluminium et d'azote soient sensiblement superposés à l'interface entre la partie supérieure et la partie inférieure de la première couche.

Selon un mode de réalisation, à l'étape b), le recuit de recristallisation en phase solide est effectué à une température comprise entre 300 et 1200°C.

Selon un mode de réalisation, lors des étapes a) et b), la première couche repose sur une couche isolante reposant elle-même sur un substrat de support.

Selon un mode de réalisation, l'étape a) comprend une première étape d'implantation ionique d'indium ou d'aluminium sur des première et deuxième parties de la surface de la première couche, suivie d'une deuxième étape d'implantation ionique d'indium ou d'aluminium localisée sur la deuxième partie seulement de la surface de la première couche.

Selon un mode de réalisation, l'étape c) est réalisée simultanément sur les première et deuxième parties de la surface de la première couche.

Selon un mode de réalisation, le dispositif électronique est un dispositif électroluminescent.

Selon un mode de réalisation, le dispositif électronique est un dispositif de conversion photoélectrique.

Selon un mode de réalisation, le dispositif électronique est un transistor HEMT.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente une étape d'un exemple d'un procédé de fabrication d'un dispositif électroluminescent selon un premier mode de réalisation ;
la figure 2 représente une autre étape d'un exemple d'un procédé de fabrication d'un dispositif électroluminescent selon le premier mode de réalisation ;
la figure 3 représente une autre étape d'un exemple d'un procédé de fabrication d'un dispositif électroluminescent selon le premier mode de réalisation ;
la figure 4 représente une autre étape d'un exemple d'un procédé de fabrication d'un dispositif électroluminescent selon le premier mode de réalisation ;
la figure 5 représente une autre étape d'un exemple d'un procédé de fabrication d'un dispositif électroluminescent selon le premier mode de réalisation ;
la figure 6 représente une autre étape d'un exemple d'un procédé de fabrication d'un dispositif électroluminescent selon le premier mode de réalisation ;
la figure 7 représente une étape d'un exemple d'un procédé de fabrication d'un dispositif électroluminescent selon un deuxième mode de réalisation ;
la figure 8 représente une autre étape d'un exemple d'un procédé de fabrication d'un dispositif électroluminescent selon le deuxième mode de réalisation ;
la figure 9 représente une autre étape d'un exemple d'un procédé de fabrication d'un dispositif électroluminescent selon le deuxième mode de réalisation ;
la figure 10 représente une autre étape d'un exemple d'un procédé de fabrication d'un dispositif électroluminescent selon le deuxième mode de réalisation ;
la figure 11 représente une autre étape d'un exemple d'un procédé de fabrication d'un dispositif électroluminescent selon le deuxième mode de réalisation ; et
la figure 12 représente une autre étape d'un exemple d'un procédé de fabrication d'un dispositif électroluminescent selon le deuxième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la composition exacte et le procédé de fabrication des couches actives des dispositifs électroluminescents décrits n'ont pas été détaillés, les modes de réalisation décrits étant compatibles avec les compositions et procédés de fabrication usuels de couches actives de dispositifs électroluminescents à base d'InGaN ou d'AlGaN, moyennant d'éventuelles adaptations à la portée de l'homme de l'art. En outre, la réalisation de métallisations de reprise de contact sur les couches semiconductrices d'anode et de cathode des cellules électroluminescentes, et d'éventuelles structures d'isolation périphériques séparant les cellules électroluminescentes voisines, n'a pas été détaillée, les modes de réalisation décrits étant compatibles avec les réalisations usuelles de ces éléments.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

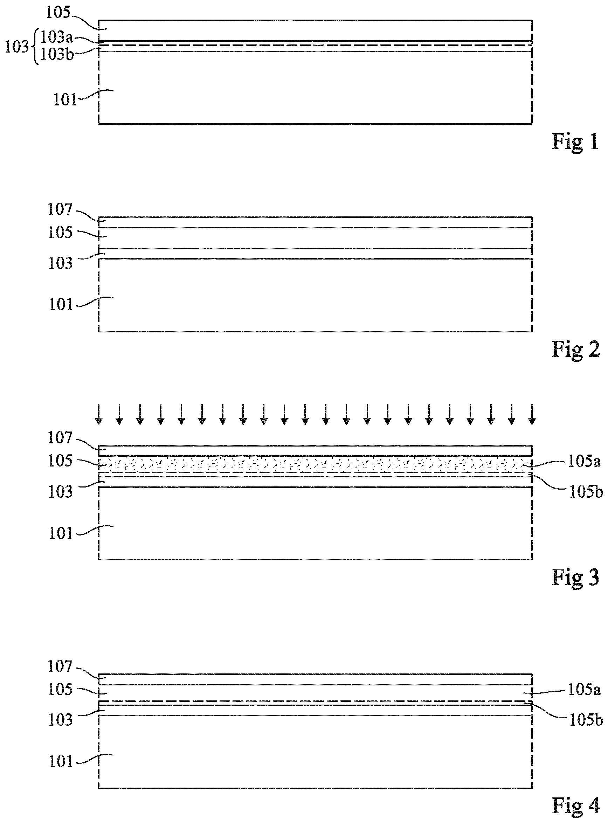

Les figures 1 à 6 sont des vues en coupe illustrant des étapes successives d'un exemple d'un procédé de fabrication d'un dispositif électroluminescent selon un premier mode de réalisation.

La figure 1 illustre une structure de départ comportant un substrat de support 101, par exemple en saphir ou en silicium, une couche isolante 103, par exemple en oxyde de silicium, revêtant la face supérieure du substrat de support 101, et une couche de nitrure de gallium (GaN) monocristallin 105 revêtant la face supérieure de la couche 103. Les faces inférieure et supérieure de la couche isolante 103 sont par exemple en contact respectivement avec la face supérieure du substrat 101 et avec la face inférieure de la couche de GaN 105.

L'empilement de la figure 1 peut être obtenu par un procédé de report comprenant :
- la formation de la couche de GaN monocristallin 105, par exemple par épitaxie en phase vapeur, sur une face d'un substrat de croissance (non représenté) ;
- la formation d'une couche d'oxyde de silicium 103a sur la face de la couche de GaN 105 opposée au substrat de croissance (la face inférieure de la couche 105 sur la figure 1) ;
- la formation d'une couche d'oxyde de silicium 103b sur une face (la face supérieure sur la figure 1) du substrat de support 101 ;
- le report de l'ensemble comportant le substrat de croissance, la couche de GaN 105 et la couche d'oxyde de silicium 103a sur l'ensemble comprenant le substrat de support 101 et la couche d'oxyde de silicium 103b, de façon à mettre en contact et fixer par collage direct ou collage moléculaire la face de la couche 103a opposée à la couche de GaN 105 à la face de la couche 103b opposée au substrat de support 101 ; et
- le retrait du substrat de croissance de façon à libérer l'accès à la face de la couche de GaN 105 opposée à la couche 103a.

De préférence, le procédé de report utilisé pour réaliser l'empilement de la figure 1 est un procédé de type SMART CUT (dénomination commerciale) dans lequel :
- une couche de GaN initialement formée sur le substrat de croissance (non représenté) présente une épaisseur supérieure à celle de la couche 105 ;
- une couche enterrée d'hydrogène est implantée dans la couche de GaN à partir de la face de la couche de GaN opposée au substrat de croissance ; et
- le retrait du substrat de croissance est réalisé par clivage de la couche de GaN initiale au niveau de la couche d'hydrogène enterrée, de façon à ne conserver sur le substrat de support que la partie de la couche de GaN disposée du côté de la couche d'hydrogène enterrée opposé au substrat de croissance (correspondant à la couche 105 de la structure de la figure 1).

L'utilisation d'un procédé de type SMART CUT présente notamment l'avantage de permettre le transfert d'une couche de GaN 105 relativement mince, de haute qualité cristalline, et relativement peu contrainte, sur la face supérieure du substrat 101.

A titre d'exemple, l'empilement de la figure 1 est obtenu par un procédé similaire au procédé décrit dans l'article intitulé "Bridging the green gap with a new foundation" de Amélie Dussaigne et David Sotta (www.compoundsemiconductor.net - juillet 2017), modifié pour remplacer le substrat donneur d'InGaN monocristallin prévu dans l'article par un substrat donneur de GaN monocristallin.

Dans les exemples décrits ci-dessus, la couche isolante intermédiaire 103 est formée par l'empilement des couches 103a et 103b. A titre d'exemple, la couche 103 présente une épaisseur comprise entre 100 nm et 1 µm, par exemple de l'ordre de 500 nm. La couche de GaN 105 a par exemple une épaisseur comprise entre 10 et 500 nm, et de préférence entre 20 et 100 nm. La couche 103 et la couche 105 s'étendent par exemple de façon continue sur sensiblement toute la surface supérieure du substrat de support 101.

La figure 2 illustre une étape de dépôt d'une couche de protection 107 sur la face supérieure de la couche de GaN 105. La couche 107 est par exemple en contact avec la face supérieure de la couche de GaN 105. La couche 107 s'étend par exemple sur sensiblement toute la surface supérieure de la couche de GaN 105. La couche 107 a notamment pour fonction d'empêcher ou de limiter l'exo-diffusion d'azote de la couche de GaN 105, et donc la décomposition du GaN de la couche 105, lors d'une étape ultérieure de recuit de recristallisation de la couche 105 (figure 4). A titre d'exemple, la couche 107 est en nitrure de silicium, par exemple en Si₃N₄. L'épaisseur de la couche 107 est par exemple comprise entre 5 et 500 nm, et de préférence entre 10 et 50 nm.

La figure 3 illustre une étape d'implantation ionique d'indium ou d'aluminium dans la couche de GaN 105, à travers la couche de protection 107. L'étape d'implantation ionique de la figure 3 permet d'introduire de l'indium ou de l'aluminium dans la couche de GaN 105 en vue de modifier sa composition pour obtenir une couche d'InGaN ou une couche d'AlGaN. L'énergie d'implantation et la dose d'implantation permettent de définir le profil de concentration du nouvel alliage. Lors de cette étape, une implantation ionique complémentaire d'azote peut être prévue pour compenser l'apport d'indium ou d'aluminium et conserver la stoechiométrie dans la profondeur du nouvel alliage formé. Les énergies et doses d'implantation sont choisies de façon à obtenir une amorphisation complète d'une partie supérieure 105a de la couche 105, et à conserver la référence cristalline d'origine dans une partie inférieure 105b de la couche 105. De préférence, l'épaisseur de la couche monocristalline inférieure de référence 105b est relativement faible pour permettre l'évacuation d'éventuelles dislocations ou autres défauts cristallins lors d'une étape ultérieure de recuit de recristallisation de la couche 105a. A titre d'exemple, l'épaisseur de la couche monocristalline inférieure de référence 105b est inférieure à la moitié de l'épaisseur de la couche 105 d'origine, par exemple inférieure à un cinquième de l'épaisseur de la couche 105 d'origine. A titre d'exemple, l'épaisseur de la couche monocristalline inférieure de référence 105b est comprise entre 2 et 100 nm, de préférence entre 2 et 10 nm. A titre d'exemple, les énergies d'implantation sont choisies de façon que les profils de concentration d'azote et d'indium ou d'azote et d'aluminium soient sensiblement superposés à l'interface entre la partie inférieure monocristalline 105b et la partie supérieure amorphe 105a de la couche 105, de façon à définir une interface nette entre les couches cristalline 105b et amorphe 105a.

La figure 4 illustre une étape de recuit de la structure obtenue à l'issue des étapes des figures 1 à 3, de façon à obtenir une recristallisation en phase solide de la partie supérieure 105a de la couche 105. Le recuit est par exemple réalisé à une température comprise entre 300 et 1200°C, par exemple entre 400 et 1000°C. La durée du recuit de recristallisation est par exemple comprise entre 1 minute et 10 heures. A titre d'exemple, le recuit est réalisé à environ 400°C pendant environ 1 heure. Lors de cette étape, on obtient une recristallisation de la couche d'InGaN ou d'AlGaN 105a. La référence cristalline est donnée par la couche monocristalline de GaN sous-jacente 105b. La proportion d'indium ou d'aluminium de la nouvelle couche cristalline 105a est définie par les doses d'implantation ionique prévues à l'étape précédente.

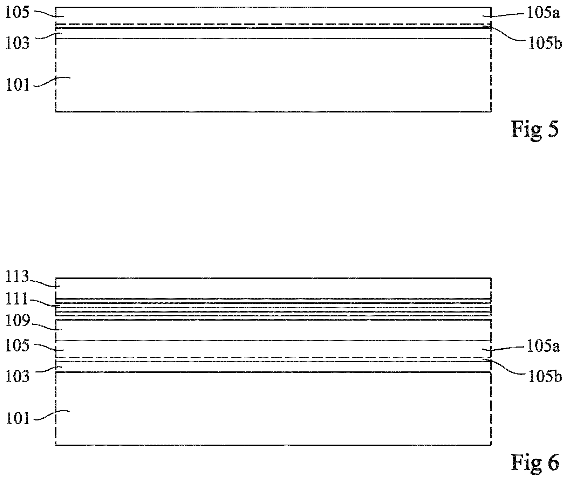

La figure 5 illustre une étape de retrait de la couche de protection 107 de façon à libérer l'accès à la face supérieure de la couche cristalline d'InGaN ou d'AlGaN 105a.

La figure 6 illustre une étape de reprise de croissance, par exemple par épitaxie en phase vapeur, à partir de la face supérieure de la couche 105a, pour réaliser la structure électroluminescente proprement dite. A titre d'exemple, l'étape de la figure 6 comprend une étape de croissance épitaxiale d'une première couche semiconductrice 109 dopée d'un premier type de conductivité, par exemple de type N, sur la face supérieure de la couche 105a, suivie d'une étape de croissance épitaxiale d'une couche active émissive 111 sur la face supérieure de la couche 105a, suivie d'une étape de croissance épitaxiale d'une couche semiconductrice 113 dopée du second type de conductivité, par exemple de type P, sur la face supérieure de la couche active 111. La couche 109 est par exemple en contact avec la face supérieure de la couche 105a. La couche active 111 est par exemple en contact avec la face supérieure de la couche 109. Une couche barrière à électrons (non visible sur la figure 6) peut éventuellement faire interface entre la couche active 111 et la couche 113. La couche 109 est par exemple en un alliage d'InGaN ou d'AlGaN de même composition que la couche 105a, mais dopé de type N. La couche active 111 comprend par exemple des moyens de confinement correspondant à des puits quantiques multiples. A titre d'exemple, la couche active 111 est constituée d'une alternance de couches semiconductrices d'un premier matériau et de couches semiconductrices d'un deuxième matériau, chaque couche du premier matériau étant prise en sandwich entre deux couches du deuxième matériau, le premier matériau ayant une bande interdite plus étroite que celle du deuxième matériau, de façon à définir des puits quantiques multiples. Dans le cas où la couche 105a est en InGaN, le premier matériau peut être de l'InGaN et le deuxième matériau peut être du GaN ou de l'InGaN ayant une concentration d'indium inférieure à celle du premier matériau. Dans le cas où la couche 105a est en AlGaN, le premier matériau peut être de l'AlGaN et le deuxième matériau peut être de l'AlGaN ayant une concentration d'aluminium supérieure à celle du premier matériau. La couche 113 est par exemple une couche d'InGaN dopée de type P dans le cas où la couche 105a est en InGaN, ou une couche d'AlGaN dopée de type P dans le cas où la couche 105a est en AlGaN.

Selon le type de dispositif électroluminescent que l'on cherche à réaliser (dispositif d'affichage d'images à cellules multiples commandables individuellement, dispositif d'éclairage à cellules multiples connectées en série ou en parallèle, dispositif d'éclairage à cellule unique, etc.) une étape ultérieure (non représentée) de gravure de tranchées verticales de singularisation de cellules électroluminescentes, traversant notamment les couches 113 et 111 de la structure de la figure 6, peut éventuellement être prévue. A titre de variante, la singularisation des cellules élémentaires du dispositif peut être réalisée avant l'étape de la figure 6 de croissance épitaxiale de la structure électroluminescente. Pour cela, on pourra par exemple graver des tranchées verticales de singularisation dans la couche 105, après le recuit de recristallisation de la partie supérieure 105a de la couche 105 et avant les étapes de dépôt de la figure 6.

Un avantage du procédé décrit en relation avec les figures 1 à 6, est que les étapes d'implantation ionique (figure 3) et de recuit de recristallisation en phase solide (figure 4) permettent d'ajuster la concentration d'indium ou d'aluminium dans la couche 105a servant de base à la croissance épitaxiale de la structure électroluminescente proprement dite (à savoir l'empilement comprenant les couches 109, 111 et 113). En particulier, ce procédé permet, en partant d'une couche monocristalline de GaN 105, d'obtenir une couche cristalline d'InGaN 105a présentant une concentration en indium relativement élevée, par exemple supérieure à 10 %, ou une couche cristalline d'AlGaN 105a présentant une concentration en aluminium relativement élevée, par exemple supérieure à 50 %. La concentration en indium ou en aluminium de la couche cristalline de base 105a peut en particulier être choisie proche de la concentration en indium ou en aluminium des couches d'InGaN ou d'AlGaN de la couche active 111. Ceci permet, lors des étapes ultérieures de croissance épitaxiale de la structure électroluminescente proprement dite, d'obtenir une bonne qualité cristalline des couches déposées et notamment de la couche active 111, y compris lorsque la concentration en indium ou en aluminium des couches de la structure électroluminescente est importante.

En particulier, dans le cas de la fabrication d'un dispositif électroluminescent à base d'InGaN, ceci constitue un avantage important par rapport aux procédés décrits dans l'article "Bridging the green gap with a new foundation" susmentionné, et dans l'article intitulé "Enhanced In incorporation in full InGaN heterostructure grown on relaxed InGaN pseudo-substrate" de A. Even et al. (Applied Physics Letters 110, 262103 (2017)), dans lesquels la croissance épitaxiale de la structure électroluminescente est réalisée à partir d'un substrat d'InGaN monocristallin formé par épitaxie en phase vapeur, dont la concentration en indium reste faible (de l'ordre de 4 %).

Un autre avantage du procédé décrit ci-dessus est que, dans la mesure où la composition de la couche de base 105a est ajustée a postériori, par implantation et recristallisation en phase solide, on peut réaliser, à partir d'une même couche monocristalline 105 d'origine, des cellules électroluminescentes dont les couches de base 105a présentent des concentrations d'indium ou d'aluminium différentes, ce que ne permettent pas les procédés décrits dans les articles susmentionnés.

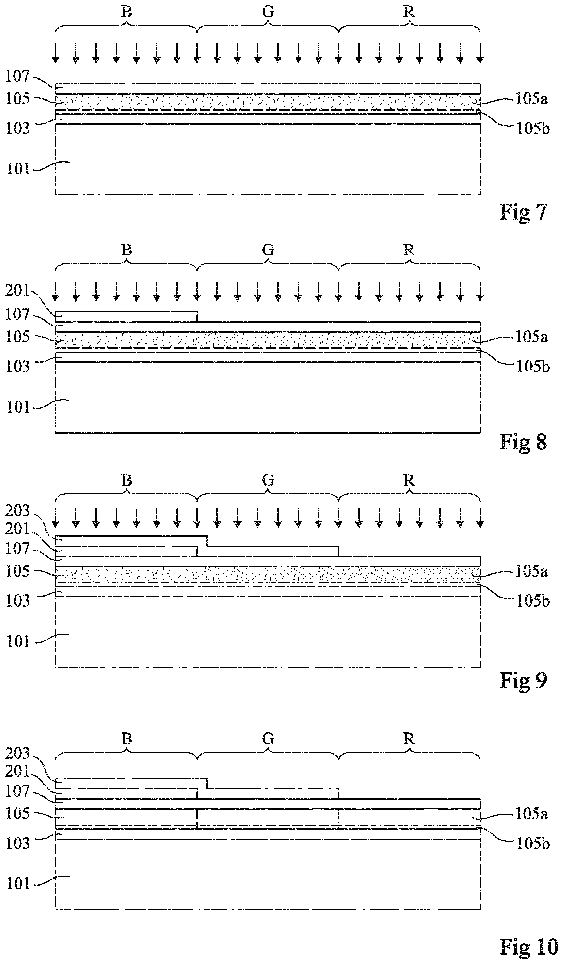

Les figures 7 à 12 sont des vues en coupe illustrant des étapes successives d'un exemple d'un procédé de fabrication d'un dispositif électroluminescent selon un deuxième mode de réalisation.

Dans le deuxième mode de réalisation, on cherche à réaliser un dispositif électroluminescent comprenant plusieurs cellules électroluminescentes adaptées à émettre dans des gammes de longueurs d'ondes différentes. On décrira ci-après plus particulièrement un exemple de réalisation d'un dispositif à base d'InGaN comportant une première cellule B adaptée à émettre majoritairement de la lumière bleue, par exemple dans une gamme de longueurs d'ondes comprise entre 400 et 490 nm, une deuxième cellule G adaptée à émettre majoritairement de la lumière verte, par exemple dans une gamme de longueurs d'ondes comprise entre 490 et 570 nm, et une troisième cellule R adaptée à émettre majoritairement de la lumière rouge, par exemple dans une gamme de longueurs d'ondes comprise entre 570 et 710 nm. L'homme de l'art saura adapter ce procédé pour réaliser tout dispositif électroluminescent à base d'InGaN ou d'AlGaN comportant au moins deux cellules adaptées à émettre dans des gammes de longueurs d'ondes différentes.

La figure 7 illustre une première étape d'implantation identique ou similaire à celle de la figure 3. Cette étape est précédée d'étapes (non représentées à nouveau) identiques ou similaires aux étapes des figures 1 et 2. Lors de l'étape de la figure 7, la dose d'indium implantée correspond à la dose nécessaire pour réaliser la cellule ayant la plus faible concentration d'indium, à savoir la cellule B dans cet exemple. A titre d'exemple, la dose d'indium implantée est choisie pour obtenir une concentration d'indium de l'ordre de 5 % dans la partie supérieure 105a de la couche 105. Cette première dose d'indium est implantée sur sensiblement toute la surface du dispositif, c'est-à-dire non seulement dans la cellule B mais aussi dans les cellules G et R.

La figure 8 illustre une étape de formation, par exemple par dépôt et gravure, d'un premier masque d'implantation 201 sur la face supérieure de la couche de protection 107. Le rôle du masque 201 est de protéger la cellule B lors d'une deuxième étape d'implantation d'indium dans les cellules G et R. A titre d'exemple, le masque 201 recouvre sensiblement toute la surface supérieure de la cellule B et ne recouvre pas la surface supérieure des cellules G et R. Le masque 201 est par exemple formée par une couche d'oxyde de silicium, par exemple d'épaisseur comprise entre 500 nm et 1 µm, par exemple de l'ordre de 600 nm, comportant des ouvertures localisées en vis-à-vis des cellules G et R.

La figure 8 illustre en outre une deuxième étape d'implantation d'indium, similaire à l'étape de la figure 7, mais au cours de laquelle seules les cellules G et R du dispositif sont implantées, la cellule B étant protégée par le masque 201. Lors de cette étape, la dose d'indium implantée correspond à la dose nécessaire pour réaliser, en tenant compte de la dose déjà implantée lors de l'étape de la figure 7, la cellule ayant la deuxième plus faible concentration d'indium, à savoir la cellule G dans cet exemple. A titre d'exemple, la dose d'indium implantée lors de l'étape de la figure 8 est choisie pour obtenir une concentration d'indium de l'ordre de 10 % dans la partie supérieure 105a de la couche 105 dans les cellules G et R. A titre d'exemple, les doses et énergies d'implantation mises en oeuvre lors de l'étape d'implantation de la figure 8 sont sensiblement les mêmes que lors de l'étape d'implantation de la figure 7.

La figure 9 illustre une étape de formation, par exemple par dépôt et gravure, d'un deuxième masque d'implantation 203 sur la face supérieure de la structure obtenue à l'issue des étapes des figures 7 et 8. Le rôle du masque 203 est de protéger la cellule G lors d'une troisième étape d'implantation d'indium dans la cellule R. A titre d'exemple, le masque 203 recouvre sensiblement toute la surface supérieure des cellules B et G et ne recouvre pas la surface supérieure de la cellule R. Le masque 203 est par exemple en le même matériau et sensiblement de même épaisseur que le masque 201.

La figure 9 illustre en outre une troisième étape d'implantation d'indium, similaire aux étapes d'implantation des figures 7 et 8, mais au cours de laquelle seule la cellule R du dispositif est implantée, les cellules B et G étant protégées par les masques 201 et 203. Lors de cette étape, la dose d'indium implantée correspond à la dose nécessaire pour réaliser, en tenant compte des doses déjà implantées lors des étapes d'implantation des figures 7 et 8, la cellule ayant la plus forte concentration d'indium, à savoir la cellule R dans cet exemple. A titre d'exemple, la dose d'indium implantée lors de l'étape de la figure 9 est choisie pour obtenir une concentration d'indium de l'ordre de 15 % dans la partie supérieure 105a de la couche 105 dans la cellule R. A titre d'exemple, les doses et énergies d'implantation mises en oeuvre lors de l'étape d'implantation de la figure 9 sont sensiblement les mêmes que lors des étapes d'implantation des figures 7 et 8.

La figure 10 illustre une étape de recuit de la structure obtenue à l'issue des étapes des figures 7 à 9, de façon à obtenir une recristallisation en phase solide de la partie supérieure 105a de la couche 105. Le recuit est par exemple réalisé dans des conditions identiques ou similaires à ce qui a été décrit ci-dessus en relation avec la figure 4. Lors de cette étape, on obtient une recristallisation de la couche d'InGaN 105a. La référence cristalline est donnée par la couche monocristalline de GaN sous-jacente 105b. La proportion d'indium de la nouvelle couche cristalline 105a est définie par les doses d'implantation ionique prévues lors des étapes précédentes. Ainsi, la concentration d'indium dans la couche 105a est plus élevée dans la cellule R que dans la cellule G, et plus élevée dans la cellule G que dans la cellule B.

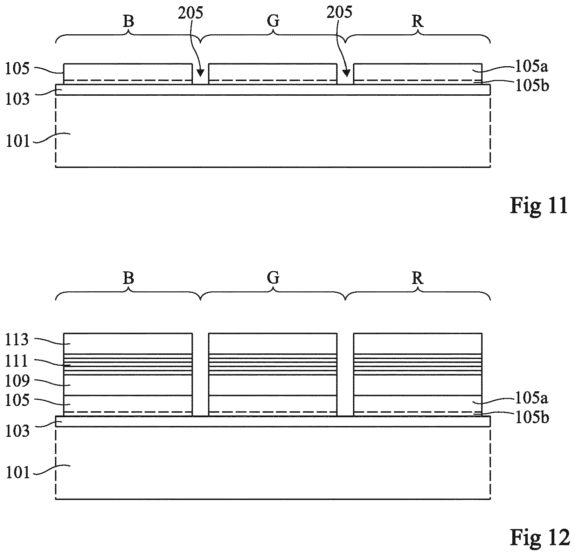

La figure 11 illustre une étape de retrait, par exemple par gravure, des masques d'implantation 201 et 203 et de la couche de protection 107, de façon à libérer l'accès à la face supérieure de la couche cristalline d'InGaN 105a sur sensiblement toute la surface du dispositif.

La figure 11 illustre en outre une étape de gravure, à partir de la face supérieure de la couche 105a, de tranchées verticales 205 délimitant latéralement et isolant les unes des autres les cellules B, G et R du dispositif. Dans l'exemple représenté, les tranchées 205 traversent entièrement la couche 105 et s'interrompent sur la face supérieure de la couche 103.

La figure 12 illustre une étape de reprise de croissance, par exemple par épitaxie en phase vapeur, à partir de la face supérieure de la couche 105a, pour réaliser les structures électroluminescentes des cellules B, G et R. A titre d'exemple, la formation des structures électroluminescentes comprend, comme dans l'exemple de la figure 6, une étape de croissance épitaxiale d'une première couche semiconductrice 109 dopée d'un premier type de conductivité, par exemple de type N, sur la face supérieure de la couche 105a, suivie d'une étape de croissance épitaxiale d'une couche active émissive 111 sur la face supérieure de la couche 105a, suivie d'une étape de croissance épitaxiale d'une couche semiconductrice 113 dopée du second type de conductivité, par exemple de type P, sur la face supérieure de la couche active 111.

Dans cet exemple, les structures électroluminescentes des cellules B, G et R sont formées simultanément, dans les mêmes conditions de croissance épitaxiale en phase vapeur. En effet, le seul fait que la concentration d'indium dans la couche de germe 105a soit différente dans les différentes cellules du dispositif permet d'obtenir des concentrations d'indium différentes dans les couches actives des différentes cellules, et donc des longueurs d'onde d'émission différentes dans les différentes cellules.

A titre de variante (non représentée), plutôt que de former les tranchées 205 de singularisation des différentes cellules avant la croissance des structures électroluminescentes tel que décrit ci-dessus, on pourra faire croître l'empilement électroluminescent de façon continue sur toute la surface du dispositif, puis, seulement après la croissance de l'empilement électroluminescent, graver des tranchées verticales traversant les couches 113, 111, et, éventuellement, les couches 109 et 105, délimitant latéralement et isolant les unes des autres les cellules B, G et R du dispositif.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits ne se limitent pas aux valeurs numériques mentionnées à titre d'exemple dans la description.

De plus, bien que l'on ait décrit ci-dessus uniquement des exemples de réalisation de dispositifs électroluminescents, les procédés décrits peuvent être adaptés à la réalisation de photodiodes, de transistors HEMT (de l'anglais "High Electron Mobility Transistor" - transistor à haute mobilité d'électrons), ou, plus généralement, de tout composant électronique à base de nitrure d'indium-gallium ou à base de nitrure d'aluminium-gallium.

L'objet de la protection conférée est défini par les revendications qui suivent.

## Revendications

1. Procédé de fabrication d'un dispositif électronique, comportant les étapes successives suivantes :
a) réaliser une implantation ionique d'indium ou d'aluminium dans une partie supérieure (105a) d'une première couche (105) monocristalline de nitrure de gallium, de façon à rendre amorphe la partie supérieure (105a) de la première couche (105) et à préserver la structure cristalline d'une partie inférieure (105b) de la première couche (105) ; et
b) réaliser un recuit de recristallisation en phase solide de la partie supérieure (105a) de la première couche (105), conduisant à transformer la partie supérieure (105a) de la première couche (105) en une couche cristalline de nitrure d'indium-gallium ou de nitrure d'aluminium-gallium.

2. Procédé selon la revendication 1, comprenant en outre, après l'étape b), une étape c) de dépôt, par épitaxie en phase vapeur, sur la face supérieure de la première couche (105), d'une structure électroluminescente comprenant :
- une couche semiconductrice (109) dopée d'un premier type de conductivité revêtant la face supérieure de la première couche (105) ;
- une couche active (111) revêtant la face supérieure de la couche semiconductrice (109) dopée du premier type de conductivité ; et
- une couche semiconductrice (113) dopée du second type de conductivité revêtant la face supérieure de la couche active (111).

3. Procédé selon la revendication 1 ou 2, dans lequel, lors des étapes a) et b), une couche de protection (107) recouvre la face supérieure de la première couche (105).

4. Procédé selon l'une quelconque des revendications 1 à 3, dans lequel, lors de l'étape a), les conditions d'implantation sont choisies de façon que la partie inférieure (105b) de la première couche (105) présente une épaisseur inférieure au cinquième de l'épaisseur de la première couche.

5. Procédé selon l'une quelconque des revendications 1 à 4, dans lequel, lors de l'étape a), les conditions d'implantation sont choisies de façon que la partie inférieure (105b) de la première couche (105) présente une épaisseur comprise entre 2 et 10 nm.

6. Procédé selon l'une quelconque des revendications 1 à 5, dans lequel, lors de l'étape a), une implantation complémentaire d'azote est réalisée pour compenser l'apport d'indium ou d'aluminium dans la partie supérieure (105a) de la première couche (105).

7. Procédé selon la revendication 6, dans lequel les énergies d'implantation sont choisies de façon que les profils de concentration d'indium et d'azote ou d'aluminium et d'azote soient superposés à l'interface entre la partie supérieure (105a) et la partie inférieure (105b) de la première couche (105).

8. Procédé selon l'une quelconque des revendications 1 à 7, dans lequel, à l'étape b), le recuit de recristallisation en phase solide est effectué à une température comprise entre 300 et 1200°C.

9. Procédé selon l'une quelconque des revendications 1 à 8, dans lequel le recuit de recristallisation en phase solide est effectué à environ 400°C pendant environ 1 heure.

10. Procédé selon l'une quelconque des revendications 1 à 9, dans lequel, lors des étapes a) et b), la première couche (105) repose sur une couche isolante (103) reposant elle-même sur un substrat de support (101).

11. Procédé selon l'une quelconque des revendications 1 à 10, dans lequel l'étape a) comprend une première étape d'implantation ionique d'indium ou d'aluminium sur des première et deuxième parties de la surface de la première couche (105), suivie d'une deuxième étape d'implantation ionique d'indium ou d'aluminium localisée sur la deuxième partie seulement de la surface de la première couche (105).

12. Procédé selon la revendication 11 dans son rattachement à la revendication 2, dans lequel l'étape c) est réalisée simultanément sur les première et deuxième parties de la surface de la première couche (105).

13. Procédé selon l'une quelconque des revendications 1 à 12, dans lequel le dispositif électronique est un dispositif électroluminescent.

14. Procédé selon l'une quelconque des revendications 1 à 12, dans lequel le dispositif électronique est un dispositif de conversion photoélectrique.

15. Procédé selon l'une quelconque des revendications 1 à 12, dans lequel le dispositif électronique est un transistor HEMT.

## Patentansprüche

1. Ein Verfahren zur Herstellung einer elektronischen Vorrichtung das die folgenden aufeinanderfolgenden Schritte aufweist:
a) Durchführen einer lonenimplantation von Indium oder Aluminium in einen oberen Teil (105a) einer ersten einkristallinen Gallium-Nitridschicht (105), um den oberen Teil (105a) der ersten Schicht (105) amorph zu machen und die Kristallstruktur eines unteren Teils (105b) der ersten Schicht (105) zu bewahren; und
b) Durchführen eines Festphasen-Rekristallisations-Glühens des oberen Teils (105a) der ersten Schicht (105), was dazu führt, dass der obere Teil (105a) der ersten Schicht (105) in eine kristalline Indium-Gallium-Nitrid- oder Aluminium-Gallium-Nitridschicht umgewandelt wird.

2. Das Verfahren nach Anspruch 1 , ferner aufweisend, nach Schritt b), einen Schritt c) der Abscheidung durch Dampfphasenepitaxie auf der oberen Oberfläche der ersten Schicht (105) einer lichtemittierenden Struktur, die folgendes aufweist:
- eine dotierte Halbleiterschicht (109) eines ersten Leitfähigkeitstyps, die die obere Oberfläche der ersten Schicht (105) bedeckt;
- eine aktive Schicht (111), die die obere Oberfläche der dotierten Halbleiterschicht (109) des ersten Leitfähigkeitstyps bedeckt; und
- eine dotierte Halbleiterschicht (113) des zweiten Leitfähigkeitstyps, die die obere Oberfläche der aktiven Schicht (111) bedeckt.

3. Das Verfahren nach Anspruch 1 oder 2, wobei während der Schritte a) und b) eine Schutzschicht (107) die obere Oberfläche der ersten Schicht (105) bedeckt.

4. Das Verfahren nach einem der Ansprüche 1 bis 3, wobei in Schritt a) die Implantationsbedingungen so gewählt werden, dass der untere Teil (105b) der ersten Schicht (105) eine Dicke von weniger als einem Fünftel der Dicke der ersten Schicht aufweist.

5. Das Verfahren nach einem der Ansprüche 1 bis 4, wobei während des Schritts a) die Implantationsbedingungen so gewählt werden, dass der untere Teil (105b) der ersten Schicht (105) eine Dicke im Bereich von 2 bis 10 nm aufweist.

6. Das Verfahren nach einem der Ansprüche 1 bis 5, wobei während des Schritts a) eine komplementäre Implantation von Stickstoff durchgeführt wird, um den Indium- oder Aluminium-Eingang im oberen Teil (105a) der ersten Schicht (105) zu kompensieren.

7. Das Verfahren nach Anspruch 6, wobei die Implantationsenergien so gewählt werden, dass die Indium- und Stickstoff- oder Aluminium- und Stickstoff-Konzentrationsprofile an der Grenzfläche zwischen dem oberen Teil (105a) und dem unteren Teil (105b) der ersten Schicht (105) überlagert werden.

8. Das Verfahren nach einem der Ansprüche 1 bis 7, wobei in Schritt b) das Festphasen-Rekristallisations-Glühen bei einer Temperatur im Bereich von 300 bis 1.200°C durchgeführt wird.

9. Das Verfahren nach einem der Ansprüche 1 bis 8, wobei das Festphasen-Rekristallisations-Glühen bei etwa 400°C für etwa 1 Stunde durchgeführt wird.

10. Das Verfahren nach einem der Ansprüche 1 bis 9, wobei während der Schritte a) und b) die erste Schicht (105) auf einer Isolierschicht (103) aufliegt, die ihrerseits auf einem Trägersubstrat (101) aufliegt.

11. Das Verfahren nach einem der Ansprüche 1 bis 10, wobei Schritt a) einen ersten Schritt der Ionenimplantation von Indium oder Aluminium auf ersten und zweiten Teilen der Oberfläche der ersten Schicht (105) aufweist, gefolgt von einem zweiten Schritt der Ionenimplantation von Indium oder Aluminium nur auf dem zweiten Teil der Oberfläche der ersten Schicht (105).

12. Das Verfahren nach Anspruch 11 und nach Anspruch 2, wobei Schritt c) gleichzeitig auf dem ersten und dem zweiten Teil der Oberfläche der ersten Schicht (105) durchgeführt wird.

13. Das Verfahren nach einem der Ansprüche 1 bis 12, wobei die elektronische Vorrichtung eine lichtemittierende Vorrichtung ist.

14. Das Verfahren nach einem der Ansprüche 1 bis 12, wobei die elektronische Vorrichtung eine photoelektrische Umwandlungsvorrichtung ist.

15. Das Verfahren nach einem der Ansprüche 1 bis 12, wobei die elektronische Vorrichtung ein HEMT-Transistor ist.

## Claims

1. A method of manufacturing an electronic device, comprising the successive steps of:
a) performing an ion implantation of indium or of aluminum into an upper portion (105a) of a first single-crystal gallium nitride layer (105), to make the upper portion (105a) of the first layer (105) amorphous and to preserve the crystal structure of a lower portion (105b) of the first layer (105); and
b) performing a solid phase recrystallization anneal of the upper portion (105a) of the first layer (105), resulting in transforming the upper portion (105a) of the first layer (105) into a crystalline indium gallium nitride or aluminum gallium nitride layer.

2. The method of claim 1, further comprising, after step b), a step c) of deposition, by vapor phase epitaxy, on the upper surface of the first layer (105), of a light-emitting structure comprising:
- a doped semiconductor layer (109) of a first conductivity type coating the upper surface of the first layer (105);
- an active layer (111) coating the upper surface of the doped semiconductor layer (109) of the first conductivity type; and
- a doped semiconductor layer (113) of the second conductivity type coating the upper surface of the active layer (111).

3. The method of claim 1 or 2, wherein, during steps a) and b), a protection layer (107) covers the upper surface of the first layer (105).

4. The method of any of claims 1 to 3, wherein, at step a), the implantation conditions are selected so that the lower portion (105b) of the first layer (105) has a thickness smaller than one fifth of the thickness of the first layer.

5. The method of any of claims 1 to 4, wherein, during step a), the implantation conditions are selected so that the lower portion (105b) of the first layer (105) has a thickness in the range from 2 to 10 nm.

6. The method of any of claims 1 to 5, wherein, during step a), a complementary implantation of nitrogen is performed to compensate for the indium or aluminum input in upper portion (105a) of the first layer (105).

7. The method of claim 6, wherein the implantation energies are selected so that the indium and nitrogen or aluminum and nitrogen concentration profiles are superimposed at the interface between the upper portion (105a) and the lower portion (105b) of the first layer (105).

8. The method of any of claims 1 to 7 wherein, at step b), the solid phase recrystallization anneal is carried out at a temperature in the range from 300 to 1,200°C.

9. The method of any of claims 1 to 8, wherein the solid phase recrystallization anneal is carried out at approximately 400°C for approximately 1 hour.

10. The method of any of claims 1 to 9, wherein, during steps a) and b), the first layer (105) rests on an insulating layer (103) itself resting on a support substrate (101).

11. The method of any of claims 1 to 10, wherein step a) comprise a first step of ion implantation of indium or of aluminum on first and second portions of the surface of the first layer (105), followed by a second step of ion implantation of indium or of aluminum located on the second portion only of the surface of the first layer (105).

12. The method of claim 11 and of claim 2, wherein step c) is carried out simultaneously on the first and second portions of the surface of the first layer (105).

13. The method of any of claims 1 to 12, wherein the electronic device is a light-emitting device.

14. The method of any of claims 1 to 12, wherein the electronic device is a photoelectric conversion device.

15. The method of any of claims 1 to 12, wherein the electronic device is a HEMT transistor.
